# EUROPÄISCHE PATENTSCHRIFT

(11) **EP 0 847 075 B1**
(45) Veröffentlichungstag und Bekanntmachung des Hinweises auf die Patenterteilung: **02.01.2004**
(21) Anmeldenummer: 97120440.9
(22) Anmeldetag: 21.11.1997
(51) Int. Cl.: H01J 37/28, H01J 37/252

(54) **Positronenquelle**
Positron source
Source de positrons

(30) Priorität: 06.12.1996 DE 19650694
(43) Veröffentlichungstag der Anmeldung: 10.06.1998
(73) Patentinhaber: LEO Elektronenmikroskopie GmbH, 73446 Oberkochen (DE)
(72) Erfinder: Tongbhoyai, Martin Dr., D-14199 Berlin (DE); Greif, Holger Dr., D-53229 Bonn (DE); Maier, Karl Prof. Dr., D-53119 Bonn (DE)
(74) Vertreter: Gnatzig, Klaus

(56) Entgegenhaltungen:
- US-A- 4 740 694
- LYNN K G ET AL: "DEVELOPMENT OF A CONE-GEOMETRY POSITRON MODERATOR" APPLIED PHYSICS LETTERS,US,AMERICAN INSTITUTE OF PHYSICS. NEW YORK, Bd. 55, Nr. 1, 3. Juli 1989 (1989-07-03), Seiten 87-89, XP000046482 ISSN: 0003-6951
- GREIF H ET AL: "HIGH RESOLUTION POSITRON-ANNIHILATION SPECTROSCOPY WITH A NEW POSITRON MICROPROBE" APPLIED PHYSICS LETTERS,US,AMERICAN INSTITUTE OF PHYSICS. NEW YORK, Bd. 71, Nr. 15, 13. Oktober 1997 (1997-10-13), Seiten 2115-2117, XP000725863 ISSN: 0003-6951

## Beschreibung

In der EP-B1 0 205 092 ist ein Rasterelektronenmikroskop beschrieben, mit dem die Untersuchung der Probe wahlweise mit Elektronen oder mit Positronen erfolgen kann und die Probe dazu wahlweise mit Elektronen oder Positronen bestrahlt werden kann. Bei einem beschriebenen Ausführungsbeispiel werden der Positronenstrahl und der Elektronenstrahl durch einen Ablenkmagnet einander überlagert und nachfolgend entlang der optischen Achse der Magnetlinsen des Rastermikroskops geführt. Als Positronenquelle ist hier das radioaktive Nuklid ²²Na, das größtenteils e⁺-aktiv ist, eingesetzt. In Strahlrichtung ist dem radioaktiven Nuklid eine Aluminiumfolie vorgeschaltet, durch die die vom Nuklid emittierten Positronen auf thermische Energie mit einer Energiebreite von einem Elektronenvolt abgebremst werden. Diese Quelle hat eine relativ große Ausdehnung und deshalb ist der Phasenraum der Positronen wesentlich größer als der Phasenraum der Elektronen. Außerdem ist die Ausbeute dieser Art der Moderation der Positronen sehr gering, da nur die durch die komplette Aluminiumfolie hindurch diffundierten Positronen auf der gegenüberliegenden Seite der Aluminiumfolie wieder austreten. Aufgrund dieser geringen Ausbeute ist die Intensität der Positronenquelle sehr schwach und daher sind für Messungen der Elektronen/Positronenrekombination in der Probe lange Meßzeiten erforderlich. Zusätzlich tritt eine weitere Schwächung des Positronenstrahls innerhalb der Abbildungsoptik des Elektronenmikroskops auf, indem ein Großteil der Positronen im Bereich der Abbildungsoptik vom Rohr des Elektronenmikroskops absorbiert wird.

Ziel der vorliegenden Erfindung ist eine kleine intensive Positronenquelle mit geringer Energiebandbreite, die für einen Einsatz in einem Elektronenmikroskop geeignet ist. Dieses Ziel wird erfindungsgemäß durch eine Positronenquelle mit den Merkmalen des Anspruches 1 gelöst. Vorteilhafte Ausgestaltungen der Erfindung ergeben sich aus den Merkmalen der abhängigen Ansprüche.

Die erfindungsgemäße Positronenquelle enthält ein Positronen emittierendes Nuklid hoher spezifischer Aktivität als Positronenemitter und einen dem Emitter vorgeschalteten Reflexionsmoderator. Der Reflexionsmoderator ist als ein dünnes Blech aus einem Material mit negativer Austrittsarbeit für die Positronen ausgebildet und weist ein Loch mit einem emitterseitigen Durchmesser von unter 0,4 mm, vorzugsweise 0,2 mm oder 0,1 mm, auf. Der Positronenemitter ist dabei hinter dem Loch des Reflexionsmoderators angeordnet. Das Loch des Reflexionsmoderators ist vorzugsweise zylindrisch oder noch besser konisch mit einem in Richtung auf den Positronenemitter abnehmenden Lochdurchmesser ausgebildet.

Ein Reflexionsmoderator mit einem konischen Loch, das einen Durchmesser von mindestens 4,9 mm aufweist, ist aus Lynn et. al., Applied Physics Letters 55, Seiten 87-89 (1989), bekannt.

Durch die Anordnung des Positronenemitters hinter dem Loch des Reflektionsmoderators trifft ein Großteil der emittierten Positronen innerhalb des Loches auf das Moderatormaterial. Im Moderatormaterial werden die Positronen thermalisiert und anschließend mit der Austrittsenergie vom Moderatormaterial abgegeben. Da die Positronen dafür nicht durch den Moderator hindurch diffundieren müssen, sondern im Bereich der Bohrung an der Oberfläche der Bohrung verbleiben können, ist der Wirkungsgrad der Energiekonversion bei einem solchen Reflexionsmoderator wesentlich höher als bei einem Transmissionsmoderator. Bei einem Flächendurchmesser des die Positronen emittierenden Materials parallel zur Querschnittsfläche des Loches durch den Reflexionsmoderator von weniger als 0,4 mm weist diese Positronenquelle eine Ausbeute von ca. 5 x 10⁻⁴ hinter dem Moderator auf. Ein weiterer Vorteil des Reflexionsmoderators gegenüber einem Transmissionsmoderator ergibt sich aus dem Beschnitt der Positronen emittierenden Fläche, denn die von seitlich außerhalb des Loches durch den Reflexionsmoderator liegenden Flächenbereichen des Positronenemitters emittierten Positronen werden vom Moderatormaterial aufgefangen. Dadurch resultieren die geringen Lateralabmessungen der Positronenquelle; durch das kleine Loch des Reflexionsmoderators resultiert eine nahezu punktförmige Positronenquelle, deren effektive Fläche dem Lochdurchmesser entspricht. Insgesamt läßt sich der aus dem Reflexionsmoderator austretende Positronenstrahl durch die in Elektronenmikroskopen üblichen Magnetlinsen vergleichbar gut abbilden und fokussieren wie ein aus einer Glühkathode emittierter Elektronenstrahl.

Die spezifische Aktivität des die Positronen emittierenden Materials sollte größer als 10¹⁰ Bequerel (Bq) pro Gramm, vorzugsweise größer 10¹⁴ Bq pro Gramm sein. Eine Positronenquelle mit einer derart hohen spezifischen Aktivität ist beispielsweise dadurch realisierbar, daß ein trägerfreies Positronen emittierendes Nuklid, beispielsweise ²²Na, auf einen nicht-radioaktiven Träger aufgedampft wird. Durch Aufdampfen durch eine kleine Blendenöffnung mit einem Öffnungsdurchmesser von ca. 0,06 bis 0,3 mm läßt sich erreichen, daß auch der Flächendurchmesser des die Positronen emittierenden Bereiches nur einen Flächendurchmesser weniger als 0,4 mm aufweist.

Als Material für den Reflexionsmoderator kommt jegliches Material mit negativer Austrittsarbeit für Positronen in Betracht, beispielsweise Wolfram, Kupfer, Gold, Nickel, Aluminium oder feste Edelgase. Vorzugsweise wird als Moderatormaterial Wolfram eingesetzt. Die negative Austrittsarbeit bei Wolfram beträgt 2,6 Elektronenvolt und die Energieunschärfe 75 Millielektronenvolt. Dadurch weist der Positronenstrahl bereits unmittelbar hinter dem Moderator eine entsprechend geringe Energieunschärfe auf.

Das Loch durch den Reflexionsmoderator ist vorzugsweise konisch mit einem auf der Seite des Positronenemitters kleineren Durchmesser als auf der dem emittierenden Emitter abgewandten Seite. Durch diese konische Ausbildung des Loches kann ein elektrostatisches Absaugfeld zum Absaugen der Positronen besser in das Loch des Reflexionsmoderators eindringen, wodurch die Ausbeute der Quelle erhöht wird.

Vorzugsweise ist eine Justiereinheit vorgesehen, durch die der Träger, auf den das radioaktive Material aufgebracht ist, relativ zum Reflexionsmoderator in drei zueinander senkrechten Raumrichtungen justierbar ist. Durch diese Justiereinheit kann der die Positronen emittierende Bereich für eine optimale Ausbeute unmittelbar hinter dem Loch des Moderators positioniert werden.

Für einen Einsatz der Positronenquelle in Verbindung mit einer nachgeschalteten Abbildungsoptik ist weiterhin vorzugsweise eine weitere Justiereinrichtung vorgesehen, durch die entweder der Reflexionsmoderator oder die Gesamteinheit aus Reflexionsmoderator zuzüglich der Justiereinheit für den Träger des radioaktiven Materials in drei zueinander senkrechten Raumrichtungen relativ zu den Komponenten der nachgeschalteten Abbildungsoptik justierbar ist. Dadurch läßt sich die Positronenquelle optimal zur Strahlachse der Abbildungsoptik einjustieren.

Die erfindungsgemäße Positronenquelle findet vorzugsweise Anwendung in einem Elektronenmikroskop, bei dem über ein Magnetprisma der von einer Elektronenquelle emittierte Elektronenstrahl und der von der Positronenquelle emittierte Positronenstrahl einander überlagert werden. Ein solches Magnetprisma kann abbildende Eigenschaften haben und dann gleichzeitig dazu dienen, die Positronenquelle und die Elektronenquelle in dieselbe cross-over Ebene der nachgeschalteten Abbildungsoptik abzubilden. Ein solches Elektronen/Positronenmikroskop ist dann zwischen Elektronenbetrieb und Positronenbetrieb umschaltbar, indem entweder der Elektronenstrahl und/oder der Positronenstrahl in den Abbildungsstrahlengang eingekoppelt wird.

Vorzugsweise sind sowohl auf der Seite der Elektronenquelle als auch auf der Seite der Positronenquelle vor dem jeweiligen Eintritt in das Magnetprisma jeweils eine weitere Magnetlinse vorgesehen, durch die der Positronenstrahl und der Elektronenstrahl in die Bildebene des Magnetprismas fokussiert werden.

Zur weiteren Justierung der Strahlengänge sollten desweiteren auf der Seite der Positronenquelle und der Elektronenquelle je ein weiteres Doppelablenksystem unmittelbar hinter der jeweiligen Quelle vorgesehen sein. Zur Feinabstimmung zwischen dem Strahlverlauf des Positronenstrahls und dem des Elektronenstrahls sollte ein weiteres einfaches Ablenksystem unmittelbar vor Eintritt eines der Strahlengänge in das Magnetprisma, vorzugsweise auf der Seite der Positronenquelle, vorgesehen sein.

Beim Umschalten zwischen Positronen- und Elektronenbetrieb sollte vorzugsweise ausschließlich die Erregung eisenfreier Elemente im Abbildungsstrahlengang geändert werden. Dieses sind die Luftspulen, die üblicherweise zur Strahljustierung zwischen der Elektronenquelle und dem Kondensor der Abbildungsoptik, oder als Stigmator zwischen dem Kondensor und der Objektivlinse oder als elektrostatische Ablenkeinheit zum Abscannen einer Probe bei einem Rasterelektronenmikroskop vorgesehen sind. Bei einem Rasterelektronenmikroskop mit einem Ablenksystem zum Abrastern der Probe wird jedoch vorzugsweise beim Positronenbetrieb die Abtasteinheit stets auf dieselbe, fest voreingestellte Position eingestellt und das interessierende Objektdetail über eine Justiereinheit des Probenhalters in diese fest voreingestellte Position gebracht.

Nachfolgend werden Einzelheiten der Erfindung anhand des in den Figuren dargestellten Ausführungsbeispiels näher erläutert. Dabei zeigen:
- Figur 1a: die Prinzipskizze eines Rasterelektronenmikroskops mit einer erfindungsgemäßen Positronenquelle im Schnitt;
- Figur 1b: den Strahlverlauf innerhalb des Magnetprismas bei einem Rasterelektronenmikroskop gemäß Figur 1a;
- Figur 2a: eine vergrößerte Schnittdarstellung durch die Positronenquelle in Figur 1a;
- Figur 2b: eine weiterhin vergrößerte Darstellung der Positronenquelle aus Figur 2a und
- Figur 3: ein Monitorbild zur Erläuterung der Repositionierung beim Umschalten vom Elektronenbetrieb auf den Positronenbetrieb bei einem Rasterelektronenmikroskop nach Figur 1a.

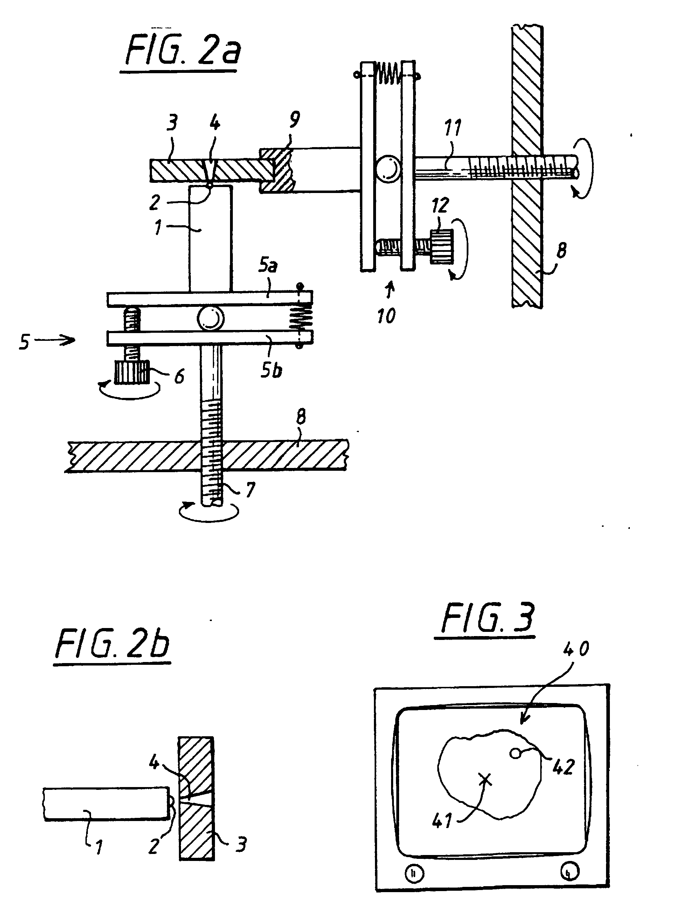

Der Aufbau der erfindungsgemäßen Positronenquelle wird zunächst anhand der Figuren 2a und 2b erläutert. Die Positronenquelle besteht aus einem Träger (1), auf den durch Aufdampfen durch eine kleine Blendenöffnung radioaktives Material (2) als Positronenemitter aufgebracht ist. Das radioaktive Material (2) ist ein e⁺-Strahler, beispielsweise ²²Na. Es handelt sich dabei um ein hochreines, trägerfreies Nuklid mit einer spezifischen e⁺-Aktivität von ca. 10¹⁴ Bq pro Gramm.

Weiterhin umfaßt die Quelle einen Reflexionsmoderator (3), der aus einem Wolframblech mit einem kleinen, vorzugsweise konischen Loch (4) ausgebildet ist. Das Loch (4) weist dabei auf der dem radioaktiven Material (2) zugewandten Seite einen Durchmesser von weniger als 0,2 mm, vorzugsweise 0,1 mm auf. Löcher mit derart kleinen Durchmessern sind durch konventionelles Bohren erreichbar. Das Loch (4) kann dabei zylindrisch oder konisch sein, wobei die konische Ausbildung bevorzugt wird, damit ein elektrostatisches Absaugfeld besser in das Loch eindringen kann.

Für eine feine Positionierung des radioaktiven Materials (2) relativ zu dem Loch (4) des Moderators (3) sind wie in der Figur 2a dargestellt zwei Justiereinrichtungen vorgesehen. Der Träger (1) für das radioaktive Material (2) ist dafür auf einer in nicht dargestellter Weise elektrisch isolierten üblichen Spiegelhalterung (5) aufgenommen, und die Spiegelhalterung (5) mittels einer Linearführung (7) relativ zu einem gerätefesten Träger (8) justierbar. Die Linearführung (7) kann einfach als eine mit einem Innengewinde im gerätefesten Rahmen (8) kämmende Gewindespindel ausgebildet sein. Durch Drehen dieser Gewindespindel (7) erfolgt eine Linearverschiebung des Spiegelhalters (5) in Achsrichtung der Gewindespindel. Die Gewindespindel (7) wiederum ist drehbar in der Trägerplatte (5b) der Spiegelhalterung (5) gelagert. Mittels zweier Stellschrauben, von denen in der Figur 2a nur eine Stellschraube (6a) dargestellt ist, ist die zweite Platte (5a) der Spiegelhalterung (5), an der der Träger (1) mit dem radioaktiven Material (2) aufgenommen ist, in zwei zur Achse der Gewindespindel (7) senkrechten Richtungen justierbar. In analoger Weise ist der Moderator (3) ebenfalls in drei zueinander senkrechten Raumrichtungen fein justierbar am Geräterahmen (8) aufgenommen. Der Reflexionsmoderator (3) ist dazu über einen Träger (9) an einer zweiten Spiegelhalterung (10) und diese zweite Spiegelhalterung (10) über eine Gewindespindel (11) aufgenommen. Durch Drehen der Gewindespindel (11) erfolgt eine Linearverschiebung der Spiegelhalterung (10) parallel zur Achse der zweiten Gewindespindel (11) und durch Verstellen der beiden Stellschrauben des Spiegelhalters (10), von denen in der Figur 2a wiederum nur eine einzige Stellschraube (12) dargestellt ist, erfolgt eine Justierung des Reflexionsmoderators (3) in den beiden zur Achse der Gewindespindel (11) senkrechten Raumrichtungen.

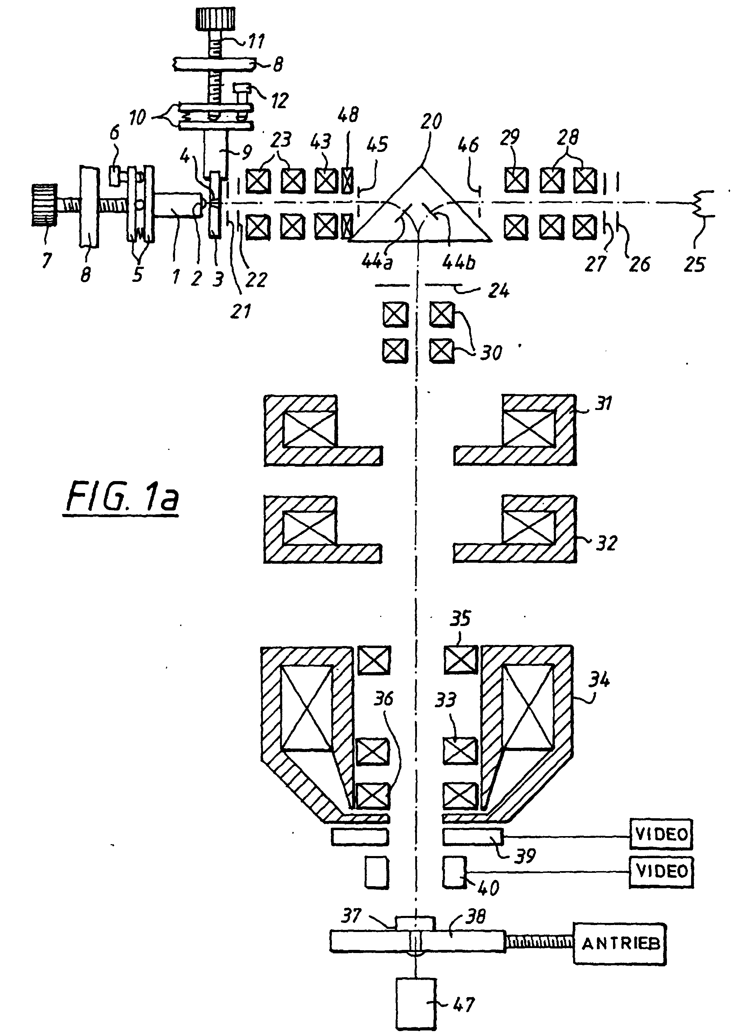

In der Figur 1a ist die erfindungsgemäße Positronenquelle in Kombination mit einem Rasterelektronenmikroskop dargestellt. Nach Austritt aus dem Moderator (3) der Positronenquelle werden die Positronen mittels einer Absaugelektrode (21), die gegenüber dem Moderator auf einem negativen Potential liegt, abgesaugt und mittels einer Beschleunigungselektrode (22) auf die gewünschte Sollenergie beschleunigt. Der Positronenemitter (2) und der Moderator liegen dabei auf positiver Hochspannung. Mittels eines durch Luftspulen realisierten Doppelablenksystems (23), einer nachfolgenden Kondensorlinse (43), einem weiteren einfachen Ablenksystem (48) und einem dem weiteren Ablenksystem (48) nachfolgenden Magnetprisma (20) wird der Positronenstrahl um 90° abgelenkt und gleichzeitig in die Eingangsquellebene (24) der nachfolgenden Abbildungsoptik abgebildet. Das Ablenksystem (48) dient dabei zur Feinjustierung des Positronenstrahls, während das Doppelablenksystem (23) zur Grobjustierung des Positronenstrahls dient.

Für die übliche Elektronenmikroskopie ist außerdem eine Elektronenquelle in Form einer Glühkathode (25) mit Wehneltelektrode (26) und Beschleunigungselektrode (27) auf der der Positronenquelle gegenüberliegenden Seite des Prismas (20) angeordnet. Anstelle einer Glühkathode (25) kann auch eine LaB₆-Kathode, eine thermische Feldemissionsquelle oder eine sonstige, "kalte" Feldemissionsquelle vorgesehen sein. Der aus der Kathode (25) emittierte Elektronenstrahl wird mittels eines weiteren Doppelablenksystems (28), einer diesem Doppelablenksystem (28) nachgeschalteten weiteren Kondensorlinse (29) und des Magnetprismas (20) ebenfalls in die Eingangsquellebene (24) abgebildet.

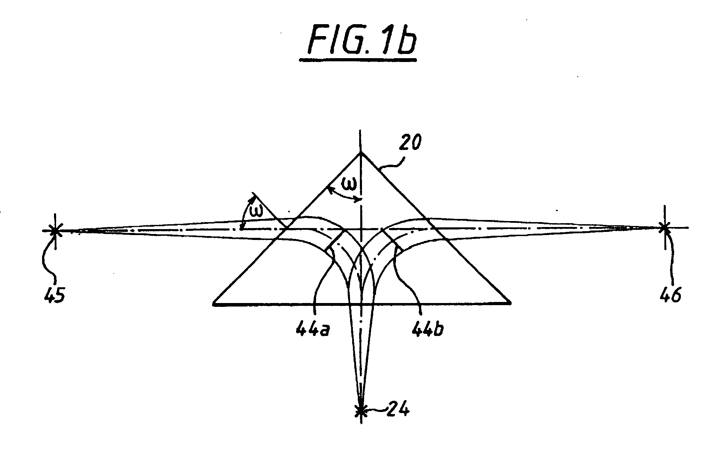

Die Strahlführung sowohl des Positronenstrahls als auch des Elektronenstrahls im Bereich des Prismas (20) ist in der Figur 1b dargestellt. Sowohl die elektronenseitige Kondensorlinse (29) als auch die positronenseitige Kondensorlinse (43) sind so erregt, daß der Crossover der Elektronenquelle in die eine Eingangsquellebene (46) und der Crossover der Positronenquelle in die andere Eingangsquellebene (45) des Magnetprismas (20) abgebildet wird. Das Magnetprisma (20) bildet dann beide Eingangsquellebenen (45, 46) in dieselbe Ausgangsquellebene mit einem Abbildungsmaßstab von ca. 0,5 ab, die mit der Eingangsquellebene (24) des nachfolgenden elektronenoptischen Abbildungssystems zusammenfällt. Für diesen Fall ist es vorteilhaft, daß in der Nähe der positronenseitigen Eingangsquellebene (45) des Magnetprismas (20) das weitere einfache Ablenksystem (48) für die Justierung des Positronenstrahls vorgesehen ist.

Alternativ können die elektronenseitige und die positronenseitige Kondensorlinsen (29, 43) auch beide so erregt sein, daß der Crossover der Positronenquelle in die eine Bildebene (44a) des Magnetprismas (20) und der Crossover der Elektronenquelle in die andere Bildebene (44b) des Magnetprismas (20) abgebildet wird. In diesem Fall muß die Eingangsquellebene (24) des nachgeschalteten Abbildungssystems mit den beiden Bildebenen (44a, 44b) des Magnetprismas (20) zusammenfallen.

In beiden Fällen hat das Magnetprisma (20) abbildende Eigenschaften, d.h. das Magnetprisma bildet drei Quellebenen (45, 46, 24) aufeinander ab; ein entsprechendes Magnetprisma ist beispielsweise vom Elektronenmikroskop EM 902 der Firma Carl Zeiss, Germany, bekannt und braucht deshalb an dieser Stelle nicht detaillierter beschrieben zu werden.

Die nachfolgende für Positronen und für Elektronen gleichermaßen genutzte Abbildungsoptik (Figur 1a) hat einen konventionellen Aufbau und enthält ein der Eingangsquellebene (24) nachgeschaltetes Doppelablenksystem (30) für die Strahljustierung, einen zweistufigen Kondensor mit Magnetlinsen (31, 32), austrittsseitig des Kondensors (31, 32) angeordnete Stigmatorspulen und ein Objektiv (34) zur Fokussierung des Teilchenstrahls auf ein Objekt (37) auf einem Objekthalter (38). Die Kondensorlinsen (31, 32) und die Objektivlinse (34) sind starke Magnetlinsen und weisen demzufolge Polschuhe aus magnetischem Weicheisen auf. Die Spulen des zur Justierung dienenden Doppelablenksystems (30) und die Spule (33) für den Stigmator sind dagegen als Luftspulen ausgebildet. In das Objektiv (34) integriert ist weiterhin ein Doppelablenksystem (35, 36), durch das in konventioneller Weise das Objekt (37) mittels des Elektronenstrahls abgerastert werden kann.

Zwischen dem Doppelablenksystem (35, 36) und dem Probenhalter (38) sind noch zwei Detektoren (39, 40) vorgesehen, von denen der eine zur Detektion von Rückstreuelektronen und der andere zur Detektion von aus der Probe (37) austretenden Sekundärelektronen dient. Weitere Detektionssysteme wie z.B. Röntgenmikroanalysesysteme (EDX etc.) oder Kathodolumineszenz-Detektoren können ebenfalls vorgesehen sein. Auf der optischen Achse des Elektronenmikroskops unterhalb des Probenhalters (38) ist noch ein Gammadetektor (47) zum Nachweis der durch Rekombination eines Positrons beim Positronenbetrieb mit einem Elektron der Probe (37) emittierten Gammastrahlung angeordnet.

Aufgrund der erfindungsgemäßen Positronenquelle mit dem kleinen emittierenden Fleckdurchmesser von weniger als 0,4 mm und der Energieunschärfe von 0,0075 Elektronenvolt entspricht der Phasenraum der emittierten Positronen in etwa dem Phasenraum der von der Elektronenquelle (25) emittierten Elektronen gleicher Energie. Deshalb sind die Abbildungseigenschaften des Rasterelektronenmikroskops mit der erfindungsgemäßen Positronenquelle für Positronen und Elektronen nahezu identisch.

Wichtig für den Betrieb des Elektronenmikroskops ist weiterhin, daß der Positronenstrahl bei Positronenbetrieb und der Elektronenstrahl bei Elektronenbetrieb beide vor Eintritt in den Kondensor des Elektronenmikroskops in denselben Punkt in der Eingangsquellebene (24) abgebildet werden. Dieses erfolgt bei bereits justierter Elektronenquelle durch Justierung des Moderators (3) und des radioaktiven Elementes (2) mittels der beiden Positioniersysteme der Positronenquelle. Eventuelle Fehljustierungen zwischen Elektronenstrahl und Positronenstrahl werden dadurch je nach Einstellung des Kondensorzooms um einen Faktor von 5 mal bis 1000 mal im Zoom verkleinert.

Beim Umschalten zwischen Positronenbetrieb und Elektronenbetrieb werden lediglich die Erregungen der Luftspulen für die Strahljustierung (30), den Stigmator (33) und des Doppelablenksystemes (35, 36) verändert. Die Erregung der Kondensorlinsen (31, 32) und des Objektivs (34) bleibt dagegen unverändert. Die Änderung der Erregungen der Luftspulen erfolgt dabei so, daß den für Elektronen und Positronen entgegengesetzten Ablenkeigenschaften in den Magnetlinsen Rechnung getragen wird.

Der Untersuchungsablauf bei einem solchen kombinierten Elektronen-Positronenmikroskop erfolgt üblicherweise derart, daß zunächst das Objekt (37) mittels des Elektronenstrahls abgerastert und das Bild der Sekundärelektronen oder Rückstreuelektronen beobachtet wird. Nachfolgend werden ausgewählte Objektdetails mittels des Positronenstrahls näher untersucht. Unabhängig davon, an welcher Position innerhalb des Elektronenbildes sich das betreffende Objektdetail befindet, wird der Positronenstrahl stets auf denselben Punkt fokussiert, d.h. beim Positronenbetrieb ist das Doppelablenksystem (35, 36) stets so erregt, daß eine räumlich feststehende Positronensonde in Form des fokussierten Positronenstrahls realisiert wird. Statt den Positronenstrahl auf das interessierende Objektdetail auszurichten, wird vielmehr das interessierende Objektdetail in den Fokus des Positronenstrahls gebracht. Der mittels Positronen untersuchte Bereich des Objektes liegt, je nach Beschaffenheit des Objektes (37), zwischen 0,1 µm und 1 µm; diese je nach Objekt unterschiedlichen Bereichsgrößen ergeben sich aus den vom Objekt abhängigen Größen des Diffusionsbereiches für die Positronen bis diese sich mit einem Elektron annullieren. Die Verschiebung der Probe kann entweder manuell oder automatisch erfolgen. Bei manueller Verschiebung wird, wie in der Figur 3 angedeutet, die Position der Positronensonde in dem bei Elektronenbetrieb erzeugten Bild (40) durch eine Markierung (41) gekennzeichnet. Mittels des Antriebes des Probenhalters kann dann das interessierende Objektdetail (42) in die Position der Markierung (41) gebracht werden und nachfolgend auf Positronenbetrieb umgestellt werden. Letzteres geschieht dadurch, daß mittels nicht dargestellter Shutter der Elektronenstrahl zwischen der Emissionskathode (25) und dem Prisma (20) unterbrochen und ein nicht dargestellter Shutter zwischen der Positronenquelle und dem Magnetprisma (20) geöffnet wird. Bei einer automatischen Nachführung des interessierenden Objektdetails (42) ist die Position der Positronensonde relativ zum dargestellten Bild abgespeichert und das interessierende Objektdetail (42) braucht lediglich im Bild, beispielsweise mittels eines Cursors, markiert zu werden. Die Antriebssteuerung des Probenhalters (8) verfährt dann den Probenhalter (38) derart, daß das markierte Objektdetail (42) in die abgespeicherte Position der Positronensonde (41) gebracht wird.

Bei dem anhand der Figuren beschriebenen Ausführungsbeispiel eines Elektronen-Positronenmikroskops ist das Magnetprisma (20) als "dreiseitiges" Prisma realisiert. Selbstverständlich können stattdessen auch andere Magnetprismen eingesetzt werden, die gleichzeitig die Bedingung der Strahlzusammenführung und Fokussierung erfüllen, beispielsweise in Form eines vierseitigen Prismas, das vier Quellebenen ineinander abbildet; die der Austrittsseite gegenüberliegende Prismenseite bleibt dann ungenutzt. Außerdem können zur Reduzierung von Abbildungsfehlern bei der Crossover-Übertragung durch das Magnetprisma auch die Ein- und Austrittskanten des Magnetprismas durch Polschuhe mit gekrümmten Rändern gekrümmt sein.

## Patentansprüche

1. Positronenquelle zur Erzeugung eines intensiven Positronenstrahls mit geringer Energiebandbreite, mit einem Positronenemitter (2) hoher spezifischer Aktivität und einem dem Positronenemitter (2) vorgeschalteten Reflexionsmoderator (3), **gekennzeichnet dadurch, daß** der Reflexionsmoderator (3) ein Loch mit einem emitterseitigen Durchmesser von weniger als 0,4 mm aufweist.

2. Positronenquelle nach Anspruch 1, wobei die spezifische Aktivität des Positronenemitters größer als 10¹⁰ Bq/g ist.

3. Positronenquelle nach Anspruch 1 oder 2, wobei der Reflexionsmoderator (3) aus einem Material mit negativer Austrittsarbeit für Positronen besteht.

4. Positronenquelle nach einem der Ansprüche 1-3, wobei das Loch (4) durch den Reflexionsmoderator (3) konisch ist und emitterseitig einen kleineren Durchmesser als auf der vom Emitter (2) abgewandten Seite aufweist.

5. Positronenquelle nach einem der Ansprüche 1-4, wobei der Positronenemitter (2) einen Flächendurchmesser von 0,3 mm oder weniger aufweist.

6. Positronenquelle nach einem der Ansprüche 1-5, wobei der Positronenemitter (2) auf einen Träger (1) aufgebracht ist und wobei eine Justiereinheit (5, 6a, 7) zur Positionierung des Emitters (2) relativ zum Reflexionsmoderator (3) in drei Raumrichtungen vorgesehen ist.

7. Positronenquelle nach Anspruch 6, wobei eine weitere Justiereinrichtung (10, 11, 12) zur Positionierung des Reflexionsmoderators (3) in drei zueinander senkrechten Raumrichtungen vorgesehen ist.

8. Elektronenmikroskop mit einer Elektronenquelle (25), einer Positronenquelle nach einem der Ansprüche 1-7 und einem Magnetprisma (20) zur Überlagerung eines von der Elektronenquelle (25) ausgehenden Elektronenstrahls und eines von der Positronenquelle ausgehenden Positronenstrahls.

9. Elektronenmikroskop nach Anspruch 8, wobei bei einer Umschaltung zwischen Positronenbetrieb und Elektronenbetrieb ausschließlich die Erregung eisenfreier Elemente (30, 33, 35, 36) im Strahlengang geändert wird.

10. Elektronenmikroskop nach Anspruch 8 oder 9, wobei ein Ablenksystem (35, 36) zum Abrastern einer Probe (37) mit dem Elektronenstrahl vorgesehen ist und wobei beim Positronenbetrieb das Ablenksystem (35, 36) stets auf dieselbe fest voreingestellte Position eingestellt ist.

11. Elektronenmikroskop nach einem der Ansprüche 8-10, wobei mindestens ein Doppelablenksystem (30) zur Strahljustierung vor Eintritt des Positronen- oder Elektronenstrahls in die Abbildungsoptik (31, 32, 34) vorgesehen ist und wobei bei Positronenbetrieb und bei Elektronenbetrieb das Doppelablenksystem (30) unterschiedlich erregt ist.

12. Elektronenmikroskop nach einem der Ansprüche 8-11, wobei unmittelbar hinter der Elektronenquelle (25) und unmittelbar hinter der Positronenquelle (2, 3, 4) jeweils ein Doppelablenksystem (23, 28) und nachfolgend jeweils eine Magnetlinse (29, 43) zum Fokussieren des Positronenstrahls und des Elektronenstrahls auf die Bildebene des Magnetprismas (20) vorgesehen ist und wobei mindestens entweder im Positronenstrahl oder im Elektronenstrahl, vorzugsweise im Positronenstrahl, dem Magnetprisma (20) ein weiteres Ablenksystem (48) vorgeschaltet ist.

13. Elektronenmikroskop nach einem der Ansprüche 8-12, wobei für die unterschiedlichen Erregungen unterschiedliche Datensätze im Speicher eines Steuerungsrechners abgespeichert sind.

14. Elektronenmikroskop nach einem der Ansprüche 8-13, wobei das Magnetprisma (20) abbildende Eigenschaften aufweist und mindestens drei Quellebenen (45, 46, 24) ineinander abbildet.

## Claims

1. Positron source for generating an intensive positron beam of small energy bandwidth, having a positron emitter (2) of high specific activity, and a reflection moderator (3) connected upstream of the positron emitter (2), **characterized in that** the reflection moderator (3) has a hole with a diameter on the emitter side of less than 0.4 mm.

2. Positron source according to Claim 1, in which the specific activity of the positron emitter is greater than 10¹⁰ Bq/g.

3. Positron source according to Claim 1 or 2, in which the reflection moderator (3) consists of a material having a negative work function for positrons.

4. Positron source according to one of Claims 1-3, in which the hole (4) through the reflection moderator (3) is conical and has a smaller diameter on the emitter side than on the side averted from the emitter (2).

5. Positron source according to one of Claims 1-4, in which the positron emitter (2) has an areal diameter of 0.3 mm or less.

6. Positron source according to one of Claims 1-5, in which the positron emitter (2) is moulded on a carrier (1), and in which an adjusting unit (5, 6a, 7) is provided for positioning the emitter (2) in three spatial directions relative to the reflection moderator (3).

7. Positron source according to Claim 6, in which a further adjusting device (10, 11, 12) is provided for positioning the reflection moderator (3) in three mutually perpendicular spatial directions.

8. Electron microscope having an electron source (25), a positron source according to one of Claims 1-7, and a magnetic prism (20) for superimposing an electron beam emanating from the electron source (25) and a positron beam emanating from the positron source.

9. Electron microscope according to Claim 8, in which only the excitation of nonferrous elements (30, 33, 35, 36) in the beam path is changed when switching over between positron operation and electron operation.

10. Electron microscope according to Claim 8 or 9, in which a deflecting system (35, 36) is provided for scanning a sample (37) with the electron beam, and in which, during positron operation, the deflecting system (35, 36) is always set to the same permanently preset position.

11. Electron microscope according to one of Claims 8-10, in which at least one double deflecting system (30) is provided for beam adjustment before entry of the positron or electron beam into the optical imaging system (31, 32, 34), and in which the double deflecting system (30) is excited differently during positron operation and during electron operation.

12. Electron microscope according to one of Claims 8-11, in which provided directly downstream of the electron source (25) and directly downstream of the positron source (2, 3, 4) is in each case a double deflecting system (23, 28) and, subsequently, in each case a magnetic lens (29, 43) for focussing the positron beam and the electron beam onto the image plane of the magnetic prism (20), and in which a further deflective system (48) is connected upstream of the magnetic prism (20) at least either in the positron beam or in the electron beam, preferably in the positron beam.

13. Electron microscope according to one of Claims 8-12, in which different data records are stored on the different excitations in the memory of a control computer.

14. Electron microscope according to one of Claims 8-13, in which the magnetic prism (20) has imaging properties and images at least three source planes (45, 46, 24) one inside another.

## Revendications

1. Source de positrons pour générer un rayon de positrons intense à faible largeur de bande énergétique, comportant un émetteur de positrons (2) à forte activité spécifique et un modérateur de réflexion (3) monté avant l'émetteur de positrons (2), **caractérisée en ce que** le modérateur de réflexion (3) présente un trou dont le diamètre du côté de l'émetteur est inférieur à 0,4 mm.

2. Source de positrons selon la revendication 1, avec laquelle l'activité spécifique de l'émetteur de positrons est supérieure à 10¹⁰ Bq/g.

3. Source de positrons selon la revendication 1 ou 2, avec laquelle le modérateur de réflexion (3) se compose d'un matériau à travail d'extraction négatif pour les positrons.

4. Source de positrons selon l'une des revendications 1 à 3, avec laquelle le trou (4) à travers le modérateur de réflexion (3) est conique et présente, du côté de l'émetteur, un diamètre inférieur à celui du côté qui se trouve à l'opposé de l'émetteur (2).

5. Source de positrons selon l'une des revendications 1 à 4, avec laquelle l'émetteur de positrons (2) présente un diamètre en surface de 0,3 mm ou moins.

6. Source de positrons selon l'une des revendications 1 à 5, avec laquelle l'émetteur de positrons (2) est monté sur un support (1) et avec laquelle il est prévu une unité de réglage (5, 6a, 7) pour positionner l'émetteur (2) par rapport au modérateur de réflexion (3) dans trois directions dans l'espace.

7. Source de positrons selon la revendication 6, avec laquelle il est prévu un dispositif de réglage supplémentaire (10, 11, 12) pour positionner le modérateur de réflexion (3) dans trois directions dans l'espace perpendiculaires les unes par rapport aux autres.

8. Microscope électronique muni d'une source d'électrons (25), d'une source de positrons selon l'une des revendications 1 à 7 et d'un prisme magnétique (20) pour superposer un rayon d'électrons sortant de la source d'électrons (25) et un rayon de positrons sortant de la source de positrons.

9. Microscope électronique selon la revendication 8, avec lequel, lors d'un basculement entre le mode positrons et le mode électrons, seule l'excitation des éléments non ferrugineux (30, 33, 35, 36) est modifiée dans le trajet du rayon.

10. Microscope électronique selon la revendication 8 ou 9, avec lequel il est prévu un système de déviation (35, 36) pour quadriller un échantillon (37) avec le rayon d'électrons et avec lequel, en mode positrons, le système de déviation (35, 36) est toujours réglé sur la même position fixe prédéfinie.

11. Microscope électronique selon l'une des revendications 8 à 10, avec lequel il est prévu au moins un double système de déviation (30) pour ajuster le rayon avant la pénétration du rayon d'électrons ou de positrons dans l'optique de représentation (31, 32, 34) et avec lequel le double système de déviation (30) est excité différemment en mode positrons et en mode électrons.

12. Microscope électronique selon l'une des revendications 8 à 11, avec lequel il est à chaque fois prévu un double système de déviation (23, 28) directement derrière la source d'électrons (25) et directement derrière la source de positrons (2, 3, 4) et après à chaque fois une lentille magnétique (29, 43) pour concentrer le rayon de positrons et le rayon d'électrons sur le plan d'image du prisme magnétique (20) et avec lequel un système de déviation supplémentaire (48) est monté avant le prisme magnétique (20), au moins soit dans le rayon de positrons ou dans le rayon d'électrons, de préférence dans le rayon de positrons.

13. Microscope électronique selon l'une des revendications 8 à 12, avec lequel différents jeux de données pour les différentes excitations sont enregistrés dans la mémoire d'un ordinateur de commande.

14. Microscope électronique selon l'une des revendications 8 à 13, avec lequel le prisme magnétique (20) présente des propriétés d'imagerie et représente au moins trois plans de source (45, 46, 24) l'un derrière l'autre.
